(19) Europäisches Patentamt
European Patent Office
Office européen des brevets

(11) EP 4 495 178 A1

(12) **EUROPEAN PATENT APPLICATION**
published in accordance with Art. 153(4) EPC

(43) Date of publication:
**22.01.2025 Bulletin 2025/04**

(21) Application number: **23857501.3**

(22) Date of filing: **07.06.2023**

(51) International Patent Classification (IPC):
***C08K 7/26*** *(2006.01)* ***C08K 3/36*** *(2006.01)*
***C08L 23/08*** *(2025.01)* ***C08J 5/18*** *(2006.01)*
***H01L 31/048*** *(2014.01)* ***C08K 3/34*** *(2006.01)*

(52) Cooperative Patent Classification (CPC):
**C08J 5/18; C08K 3/34; C08K 3/36; C08K 7/26; C08L 23/08; H01L 31/048**

(86) International application number:
**PCT/KR2023/007772**

(87) International publication number:
**WO 2024/043462 (29.02.2024 Gazette 2024/09)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.08.2022 KR 20220107003**
**06.09.2022 KR 20220112873**
**03.04.2023 KR 20230043750**

(71) Applicant: **LG Chem, Ltd.**
**Yeongdeungpo-gu**
**Seoul 07336 (KR)**

(72) Inventors:
- **LEE, Young Woo**
  **Daejeon 34122 (KR)**
- **GONG, Jin Sam**
  **Daejeon 34122 (KR)**
- **JUN, Jung Ho**
  **Daejeon 34122 (KR)**
- **LEE, Eun Jung**
  **Daejeon 34122 (KR)**
- **HONG, Sang Hyun**
  **Daejeon 34122 (KR)**
- **LEE, Hye Ji**
  **Daejeon 34122 (KR)**
- **HAN, Sang Wook**
  **Daejeon 34122 (KR)**

(74) Representative: **Hoffmann Eitle**
**Patent- und Rechtsanwälte PartmbB**
**Arabellastraße 30**
**81925 München (DE)**

(54) **ENCAPSULATION FILM COMPOSITION AND ENCAPSULATION FILM COMPRISING SAME**

(57) The present invention relates to an encapsulant film composition, an encapsulant film, and a solar cell module, the composition including an ethylene/alpha-olefin copolymer and having excellent compatibility with a crosslinking additive.

EP 4 495 178 A1

## Description

## TECHNICAL FIELD

### Cross-reference to Related Applications

This application claims the benefit of Korean Patent Application No. 10-2022-0107003, filed on August 25, 2022, Korean Patent Application No. 10-2022-0112873, filed on September 06, 2022, and Korean Patent Application No. 10-2023-0043750, filed on April 03, 2023 in the Korean Intellectual Property Office, the disclosures of which are incorporated herein in its entirety by reference.

### Technical Field

The present invention relates to an encapsulant film composition, an encapsulant film, and a solar cell module.

## BACKGROUND ART

As global environmental problems, energy problems, etc. are getting worse and worse, solar cells are attracting attention as a means of generating energy without environmental pollution and depletion. When solar cells are used outdoors, such as the roof of a building, a module type thereof is generally used. In order to obtain a crystalline solar cell module when a solar cell module is produced, front glass/solar cell encapsulant/crystalline solar cell element/solar cell encapsulant/back glass (or back protective sheet) are stacked in this order. As the solar cell encapsulant, an ethylene/vinyl acetate copolymer or ethylene/alpha-olefin copolymer having excellent transparency, flexibility, adhesion, or the like is generally used.

The solar cell module is packaged by protecting a solar cell element including such materials such as silicon, gallium-arsenic, and copper-indium-selenium with a top transparent protective material and a bottom substrate protective material, and fixing the solar cell element and the protective material with an encapsulant. Generally, the encapsulant of the solar cell element in the solar cell module is produced by extruding a sheet from an ethylene/alpha-olefin copolymer in which an organic peroxide or a silane coupling agent has been mixed, and the encapsulant in the form of sheet thus obtained is used to encapsulate the solar cell element to produce a solar cell module.

When the solar cell module as described above is produced, in order to improve productivity, one method may be to increase the affinity between the ethylene/alpha-olefin copolymer and various raw materials included in the encapsulant film composition, thereby increasing absorbency. In particular, a crosslinking agent, a crosslinking aid, and the like, which are essentially used for producing an encapsulant film, are polar substances and thus have a low absorbency for a non-polar ethylene/alpha-olefin copolymer, which is pointed out as one of the factors that cause a decrease in the productivity.

[Prior Art Document]

[PATENT DOCUMENT]

(Patent Document 1) Japanese Laid-open Patent No. 2015-211189

## DISCLOSURE OF THE INVENTION

## TECHNICAL PROBLEM

The purpose of the present invention is to reduce the impregnation time of an ethylene/alpha-olefin copolymer at an initial stage during the production of an encapsulant film and to reduce the transfer rate of a crosslinking agent component impregnated in an encapsulant film composition.

## TECHNICAL SOLUTION

In order to solve the above problem, the present invention provides an encapsulant film composition, an encapsulant film, and a solar cell module.

(1) According to an aspect of the present invention, there is provided an encapsulant film composition, wherein a ratio of an Si-O band integral value to a C-H band integral value (Si-O band integral value/C-H band integral value) is 3 to 70 when calculated from an FT-IR spectrum.

(2) In (1) above of the present invention, there is provided the encapsulant film composition, wherein when the encapsulant film is produced using the encapsulant film composition and a crosslinking agent, the transfer rate of the crosslinking agent represented by Equation 1 below is at most 4.5%.

Transfer rate of crosslinking agent (%) = [weight of crosslinking agent transferred to surface of encapsulant film/total weight of crosslinking agent] $\times$ 100 [Equation 1]

In Equation 1 above,

the weight of the crosslinking agent transferred to the surface of the film is a value measured after preparing an encapsulant film using the encapsulant film composition and then storing the encapsulant film at -5 °C for one week, and
the total weight of the crosslinking agent is the total weight of the crosslinking agent included in the encapsulant film.

(3) In (1) or (2) above of the present invention, there is provided the encapsulant film composition, wherein the ratio of the Si-O band integral value to the C-H band integral value (Si-O band integral value/C-H band integral value) is 10 to 50, when calculated from the FT-IR spectrum.
(4) In any one of (1) to (3) above of the present invention, there is provided the encapsulant film composition, wherein the transfer rate of the crosslinking agent is 0.1 to 4.3.
(5) In any one of (1) to (4) above of the present invention, there is provided the encapsulant film composition, wherein the encapsulant film composition includes ethylene/alpha-olefin copolymer and porous silica.
(6) In (5) above of the present invention, there is provided the encapsulant film composition, wherein the porous silica has an oil absorption of greater than 40 mL/100g as measured according to ASTM D1483-12 (2016).
(7) In (5) or (6) above of the present invention, there is provided the encapsulant film composition, wherein in the porous silica, a -OH content of a silanol group is at least 1.0 wt% based on the total weight of the porous silica.
(8) In any one of (1) to (7) of the present invention, there is provided the encapsulant film composition, further including at least one selected from the group consisting of an organic peroxide, a crosslinking aid, a silane coupling agent, an unsaturated silane compound, an amino silane compound, a light stabilizer, a UV absorber, and a thermal stabilizer.
(9) According to another aspect of the present invention, there is provided an encapsulant film including the encapsulant film composition of any one of (1) to (8).
(10) According to still another aspect of the present invention, there is provided a solar cell module including the encapsulant film of (9) above.

## ADVANTAGEOUS EFFECTS

When an encapsulant film is produced using the encapsulant film composition according to the present invention, the impregnation time of an ethylene/alpha-olefin copolymer is reduced so that the economic viability of a process of producing an encapsulant film can be improved. In addition, by delaying the transfer of the crosslinking agent composition component, it is possible to suppress a slip phenomenon of the encapsulant film, which may occur during the automation process of producing a module.

## MODE FOR CARRYING OUT THE INVENTION

Hereinafter, the present invention will be described in more detail to aid in understanding the present invention.
Terms or words used in the specification and claims should not be interpreted as being limited to a conventional or dictionary meaning, and should be interpreted as the meaning and concept that accord with the technical spirit on the grounds of the principle that the inventor can appropriately define the concept of the term in order to explain invention in the best way.

### <Encapsulant Film Composition>

An encapsulant film composition of the present invention has a ratio of an Si-O band integral value to a C-H band integral value (Si-O band integral value/C-H band integral value) of 3 to 70, when calculated from an FT-IR spectrum.
The encapsulant film composition of the present invention includes an ethylene/alpha-olefin copolymer. The ethylene/alpha-olefin copolymer is prepared by copolymerizing ethylene and an alpha-olefin-based monomer, in which the alpha-olefin, which refers to a portion derived from the alpha-olefin-based monomer in the copolymer, may include alpha-olefin having 4 to 20 carbon atoms, specifically, propylene, 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, or the like, and may be one alone or a mixture of two or more thereof.

Among these, the alpha-olefin may be 1-butene, 1-hexene, or 1-octene, and preferably may be 1-butene, 1-hexene, or a combination thereof.

In addition, the content of the alpha-olefin in the ethylene/alpha-olefin copolymer may be appropriately selected within a range satisfying the above-described physical properties, and specifically, may be 0-99 mol% (exclusive of 0), and 10-50 mol%, but is not limited thereto.

In the present invention, a method for preparing an ethylene/alpha-olefin copolymer or an obtaining route thereof is not limited, and a person skilled in the art may select and use an appropriate one in consideration of the physical properties and purpose of an encapsulant film composition.

The ethylene/alpha-olefin copolymer included in the encapsulant film composition of the present invention may have a density in a range of 0.850-0.910 g/cc, and in this case, the density may mean a density measured according to ASTM D-792-20. More specifically, the density may be at least 0.855 g/cc, at least 0.860 g/cc, at least 0.865 g/cc, or at least 0.870 g/cc, and at most 0.905 g/cc, at most 0.900 g/cc, or at most 0.895 g/cc.

In general, when the ethylene/alpha-olefin copolymer is used in the encapsulant film composition, the lower the density of the copolymer is, the lower the crystallinity, and thus the optical transparency is high, and the time required for impregnating the crosslinking agent is reduced, but if the density of the copolymer is too low, blocking occurs between pellets during pellet storage and thus a pellet injection process may not be easy, and during sheet formation, it may become easy to stick to the surface of a winding roll, blocking between sheets can be caused, and thus there occurs a limitation in the feeding property of the sheet, thereby causing various limitations in the process of producing a sheet for an encapsulant film.

However, the encapsulant film composition of the present invention includes the ethylene/alpha-olefin copolymer having the density, and increases resistance to blocking and stickiness of pellets and sheets, and also improves the limitation of impregnation time delay involved when ethylene/alpha-olefin copolymers have conventionally been used.

In addition, the encapsulant film composition of the present invention exhibits excellent compatibility with a crosslinking agent through silanol groups and siloxane groups in the encapsulant film composition, thereby reducing the transfer rate of the crosslinking agent component according to changes over time and exhibiting excellent slip resistance on a glass substrate.

The encapsulant film composition of the present invention may include porous silica. As described above, by including the porous silica, when the encapsulant film composition of the present invention is calculated from the FT-IR spectrum, the ratio of the Si-O band integral value to the C-H band integral value (Si-O band integral value/C-H band integral value) is calculated to be 3 to 70.

A Fourier Transformation-Infrared (FT-IR) instrument is one of the basic instruments among the spectrometers and is an instrument for determining the presence or absence of most chemical functional groups, and when infrared rays are irradiated onto a sample, a part of the irradiated light is absorbed into the sample and appears as a specific peak, and the sample may be characterized through the specific peak.

The specific peak is a peak that appears only in a specific functional group, and the location of the peak can be checked in a handbook.

The Si-O band integral value may be an integral value in a region of 1016 $cm^{-1}$ to 1247 $cm^{-1}$, and the C-H band integral value may be an integral value in a region of 1975 $cm^{-1}$ to 2110 $cm^{-1}$.

More specifically, the ratio of the Si-O band integral value to the C-H band integral value (Si-O band integral value/C-H band integral value) may be 3 to 70, specifically 4 to 60, or 5 to 50.

This means that, in the encapsulant film composition of the present invention, when the Si-O component in the porous silica is greater than or equal to a predetermined amount, there is a large amount of sites capable of hydrogen bonding with a carbonyl group of the crosslinking agent, and this may act as a factor that can increase an impregnation speed in the crosslinking agent impregnation reaction, thus reducing the impregnation process time.

In addition, when the encapsulant film composition of the present invention and the crosslinking agent are used to produce the encapsulant film, the transfer rate of the crosslinking agent represented by Equation 1 below may be at most 4.5%.

$$\text{Transfer rate of crosslinking agent (\%)} = [\text{weight of crosslinking agent transferred to surface of film/total weight of crosslinking agent}] \times 100 \quad \text{[Equation 1]}$$

In Equation 1 above,

the weight of the crosslinking agent transferred to the surface of the film is a value measured after preparing an encapsulant film using the encapsulant film composition and then storing the encapsulant film at -5 °C for one week,

and

the total weight of the crosslinking agent is the total weight of the crosslinking agent included in the encapsulant film.

The encapsulant film composition of the present invention includes porous silica, and the porous silica satisfies a predetermined amount of -OH content of a silanol group and a predetermined value of specific surface area. The encapsulant film composition of the present invention includes the porous silica satisfying a predetermined amount of a -OH content of a silanol group and a predetermined value of specific surface area, and thus the transfer of the crosslinking agent component is suppressed and the composition may exhibit a low transfer rate of the crosslinking agent.

Specifically, the transfer rate of the crosslinking agent represented by Equation 1 may be at most 4.5 wt%, and specifically 0.1-4.3 wt%, or 0.5-4.3 wt%. As described above, by exhibiting a low transfer rate of the crosslinking agent, physical properties may be continuously maintained as an encapsulant film when the encapsulant film is produced using the crosslinking agent, and excellent slip resistance on the glass substrate may be exhibited during the process of producing a solar cell module.

The encapsulant film composition of the present invention may include an ethylene/alpha-olefin copolymer and porous silica.

The porous silica may have an oil absorption of greater than 40 mL/100g as measured according to ASTM D1483-12 (2016).

Specifically, the oil absorption of the porous silica may be greater than 40 mL/100g, more specifically, 60-500 mL/100g, for example, greater than 40 mL/100g, at least 60 mL/100g, at least 70 mL/100g, at least 80 mL/100g, at least 100 mL/100g, or at least 130 mL/100g, and at most 500 mL/100g, at most 450 mL/100g, at most 400 mL/100g, at most 300 mL/100g, or at most 200 mL/100g.

The oil absorption of the porous silica used in the present invention is within the above range, which means that the porous silica has excellent absorbency with respect to the liquid crosslinking agent. In particular, in the present invention, by using the porous silica having a high oil absorption greater than 40 mL/100g, when used in the encapsulant film composition, excellent oil absorption characteristics with respect to a liquid component additive of the porous silica, and a hydrogen bonding effect between a hydroxyl group in the silica and a carbonyl group in the crosslinking agent result in a reduction in the impregnation time of the crosslinking agent, and a low transfer rate of the crosslinking agent.

The -OH content of the silanol group (Si-O-H) of the porous silica may be at least 1.0 wt%, specifically at least 1.5 wt%, at least 2.0 wt%, at least 2.5 wt%, at least 3.0 wt%, at most 5.0 wt%, or at most 4.5 wt% based on the total weight of the porous silica.

When the -OH content of the silanol group satisfies the above range, when the encapsulant film composition including the ethylene/alpha-olefin copolymer and the porous silica is stored for a long period of time, the transfer phenomenon toward the surface of the crosslinking agent may be suppressed, and the absorption rate of the crosslinking agent may be improved. When the -OH content of the silanol group is insufficient, the transfer of the crosslinking agent may be insufficiently suppressed, and when the -OH content of the silanol group is excessive, moisture in the air is adsorbed thereto, causing a side reaction when mixing with the crosslinking agent and the silane coupling agent, thereby reducing the degree of crosslinking and adhesive strength.

In addition, the specific pore volume of the porous silica may be greater than 0.1 mL/g, specifically, 0.2-5.0 mL/g, for example, at least 0.2 mL/g, at least 0.3 mL/g, at least 0.5 mL/g, at least 0.7 mL/g, at most 5.0 mL/g, at most 3.0 mL/g, at most 2.5 mL/g, at most 2.0 mL/g, or at most 1.0 mL/g.

The specific pore volume of the porous silica used in the present invention is within the above range, which means that the porous silica has excellent absorbency with respect to the liquid crosslinking agent. In particular, in the present invention, by using the porous silica having a large specific pore volume greater than 0.1 mL/g, when used in the encapsulant film composition, the crosslinking agent is efficiently absorbed, thereby exhibiting an effect of reducing the impregnation time of the crosslinking agent.

In addition, the porous silica of the present invention has the feature of satisfying both the oil absorption and the specific pore volume as described above, and if neither of the two is within the above range, there may occur a limitation in that the liquid crosslinking agent is not well absorbed, which may act as a factor that prevents the impregnation of the crosslinking agent.

In addition, when the porous silica is used, the effect of increasing the volume resistivity is also exhibited. This is because the porous silica acts as an insulator, and particularly, this effect is exhibited when the porous silica having the oil absorption and the specific pore volume is used.

In the present invention, the porous silica may be 0.1-1.5 wt%, specifically 0.1-1.0 wt% based on the encapsulant film composition.

When the content of the porous silica is less than the above range, the effects of efficiently absorbing the liquid crosslinking agent by the porous silica and reducing the impregnation time of the crosslinking agent through the functional group of the porous silica are insignificant, and when the content of the porous silica is more than the above range, side effects that deteriorate the optical transparency of the encapsulant film may be caused.

In the present invention, the porous silica may have an average particle diameter of 1-20 μm, specifically, at least 1.0 μm, at least 1.2 μm, at least 2.0 μm, at most 15.0 μm, at most 14.0 μm, at most 10.0 μm, or at most 5.0 μm.

When the porous silica has the above size, the porous silica is well dispersed in an encapsulant sheet to maintain optical transparency, and when the encapsulant sheet is wound and stored, it is possible to suppress sheet blocking due to the low density of the ethylene/alpha-olefin copolymer. In addition, it is possible to suppress appearance defects caused by uneven surface of the sheet due to too large average particle diameter of the porous silica.

In addition, in the present invention, the porous silica may have a specific surface area of 40-800 $m^2/g$, specifically, at least 50 $m^2/g$, at least 100 $m^2/g$, at least 150 $m^2/g$, at least 200 $m^2/g$, at least 300 $m^2/g$, at least 400 $m^2/g$, at most 750 $m^2/g$, at most 700 $m^2/g$, or at most 600 $m^2/g$. When the specific surface area of the porous silica is within the above range, the bonding between the silanol group (or the functional group including OH) of the porous silica and the polar group of the crosslinking agent may be efficiently performed, thereby reducing the impregnation time of the crosslinking agent.

The encapsulant film composition of the present invention may further include at least one selected from the group consisting of a known organic peroxide, a crosslinking aid, a silane coupling agent, an unsaturated silane compound, an amino silane compound, a light stabilizer, a UV absorber, and a thermal stabilizer, in addition to the above-described ethylene/alpha-olefin copolymer and porous silica.

The encapsulant film composition of the present invention includes a crosslinking agent. The crosslinking agent is a radical initiator in the preparation step of the silane modified resin composition and may play the role of initiating the grafting reaction of the unsaturated silane compound into the resin composition. In addition, by forming a crosslinking bond in the silane modified resin composition or between the silane modified resin composition and an unmodified resin composition in the step of lamination during manufacturing an optoelectronic device, the heat resistance and durability of a final product, for example, an encapsulant sheet may be improved.

The crosslinking agent may use various crosslinking agents known in the art as long as it may be a crosslinking agent which may initiate the radical polymerization of a vinyl group or form a crosslinking bond, for example, one or two or more selected from the group consisting of an organic peroxide, a hydroperoxide and an azo compound may be used.

For example, the encapsulant for a solar cell may include organic peroxide as a crosslinking agent, and the organic peroxide serves to improve weather resistance of the encapsulant for a solar cell.

In particular, one or more selected from the group consisting of: dialkyl peroxides such as t-butylcumylperoxide, di-t-butyl peroxide, di-cumyl peroxide, 2,5-dimethyl-2,5-di(t-butylperoxy) hexane, and 2,5-dimethyl-2,5-di(t-butylperoxy)-3-hexyne; hydro peroxides such as cumene hydroperoxide, diisopropyl benzene hydro peroxide, 2,5-dimethyl-2,5-di(hydroperoxy)hexane, and t-butylhydroperoxide; diacyl peroxides such as bis-3,5,5-trimethylhexanoyl peroxide, octanoylperoxide, benzoyl peroxide, o-methylbenzoylperoxide, and 2,4-dichlorobenzoyl peroxide; peroxy esters such as t-butylperoxy iso butyrate, t-butylperoxy acetate, t-butylperoxy-2-ethylhexylcarbonate (TBEC), t-butylperoxy-2-ethylhexanoate, t-butylperoxy pivalate, t-butylperoxy octoate, t-butylperoxyisopropyl carbonate, t-butylperoxybenzoate, dit-butylperoxyphthalate, 2,5-dimethyl-2,5-di(benzoylperoxy)hexane, and 2,5-dimethyl-2,5-di(benzoylperoxy)-3-hexyne; ketone peroxides such as methyl ethyl ketone peroxide, and cyclohexanone peroxide, and azo compounds such as lauryl peroxide, azobisisobutyronitrile and azobis(2,4-dimethylvaleronitrile), may be included, but are not limited thereto.

The organic peroxide may be an organic peroxide having a one-hour half-life temperature of 120 °C to 135 °C, for example, 120 °C to 130 °C, 120 °C to 125 °C, preferably, 121 °C. The "one-hour half-life temperature" means a temperature at which the half-life of the crosslinking agent becomes one hour. According to the one-hour half-life temperature, the temperature at which the radical initiation reaction is efficiently carried out is changed, and accordingly, if an organic peroxide having the one-hour half-life temperature in the above-described range is used as the crosslinking agent, radical initiation reaction, that is, crosslinking reaction may be effectively performed at a lamination process temperature for manufacturing an optoelectronic device.

The crosslinking agent may be contained in an amount of 0.01-2 parts by weight, for example, 0.05-1.5 parts by weight, 0.1-1.5 parts by weight, or 0.5-1.5 parts by weight, based on 100 parts by weight of the ethylene/alpha-olefin copolymer. When the crosslinking agent is contained in the above range, an effect of improving heat resistance is sufficiently exhibited, and the moldability of the encapsulant film is also excellent, and thus a process restriction or a decrease in the physical properties of the encapsulant may not occur.

Crosslinking aid

The encapsulant film composition of the present invention may include a crosslinking aid in addition to the crosslinking agent. By including the crosslinking aid in the resin composition, the crosslinking degree between the resin compositions by the above-described crosslinking agent may be increased, and accordingly, the heat resistance and durability of a final product, for example, an encapsulant sheet may be even further improved.

Various known crosslinking aids in the art may be used as the crosslinking aid, for example, a compound

containing at least one unsaturated group such as an allyl group or a (meth)acryloxy group may be used as the crosslinking aid.

The compound containing the allyl group may include, for example, a polyallyl compound such as triallyl isocyanurate (TAIC), triallyl cyanurate, diallyl phthalate, diallyl fumarate, or diallyl maleate, and the compound containing the (meth)acrylic oxy group may include, for example, a poly(meth)acryloxy compound such as ethylene glycol diacrylate, ethylene glycol dimethacrylate, trimethylolpropane trimethacrylate, and the like, but the present invention is not particularly limited thereto.

The crosslinking aid may be contained in an amount of 0.01-0.5 parts by weight, for example, 0.01-0.3, 0.015-0.2, or 0.016-0.16 parts by weight based on 100 parts by weight of the encapsulant film composition, and if the crosslinking aid is contained in less than 0.01 parts by weight, the improving effect of heat resistant properties may be insignificant, and if the amount is greater than 0.5 parts by weight, defects of affecting the physical properties of a final product, for example, an encapsulant sheet may be caused, and production costs may increase.

Silane coupling agent

The silane coupling agent may serve to improve the adhesion between the encapsulant film and the solar cell.

As the silane coupling agent, for example, one or more selected from the group consisting of N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, and γ-methacryloxypropyltrimethoxysilane (MEMO) may be used, but the present invention is not limited thereto.

The silane coupling agent may be contained in an amount of 0.1-0.4 parts by weight based on 100 parts by weight of the encapsulant film composition. When the content of the silane coupling agent is within the above range, the solar cell module may have excellent adhesion to the glass, thereby preventing deterioration of long-term performance of the module due to the penetration of moisture.

In addition, the encapsulant film composition of the present invention may further include at least one selected from the group consisting of an unsaturated silane compound, an aminosilane compound, a light stabilizer, a UV absorber, and a thermal stabilizer.

The unsaturated silane compound may be grafted into a main chain including a polymerization unit of the monomer of the copolymer of the present invention in the presence of a radical initiator to be included in a polymerized state into a silane modified resin composition or an amino silane modified resin composition.

The unsaturated silane compound may be vinyltrimethoxy silane, vinyltriethoxy silane, vinyltripropoxy silane, vinyltriisopropoxy silane, vinyltributoxy silane, vinyltripentoxy silane, vinyltriphenoxy silane, vinyltriacetoxy silane, or the like, and in an embodiment, the vinyltrimethoxy silane or the vinyltriethoxy silane may be used among them, without limitation.

In addition, the amino silane compound may further improve the adhesive strength with the back side sheet composed of top and bottom glass substrates or a fluorine resin, by acting as a catalyst promoting hydrolysis reaction transforming a reactive functional group such as an alkoxy group of an unsaturated silane compound, for example, vinyltriethoxy silane, which is grafted into the copolymer, into a hydroxyl group in the grafting modification step of an ethylene/alpha-olefin copolymer. At the same time, the amino silane compound participates directly in a copolymerization reaction as a reactant, and a moiety having an amine functional group in an amino silane modified resin composition may be provided.

The amino silane compound may be any silane compounds including an amine group as long as it is a primary amine and a secondary amine, without specific limitation. For example, as the amino silane compound, aminotrialkoxysilane, aminodialkoxysilane, etc., may be used, and the example thereof may include one or more selected from the group consisting of 3-aminopropyltrimethoxysilane (APTMS), 3-aminopropyltriethoxysilane (APTES), bis[(3-triethoxysilyl)propyl]amine, bis[(3-trimethoxysilyl)propyl]amine, 3-aminopropylmethyldiethoxysilane, 3-aminopropylmethyldimethoxysilane, N-[3-(trimethoxysilyl)propyl]ethylenediamine (DAS), aminoethylaminopropyltriethoxysilane, aminoethylaminopropylmethyldimethoxysilane, aminoethylaminopropylmethyldiethoxysilane, aminoethylaminomethyltriethoxysilane, aminoethylaminomethylmethyldiethoxysilane, diethylenetriaminopropyltrimethoxysilane, diethylenetriaminopropyltriethoxysilane, diethylenetriaminopropylmethyldimethoxysilane, diethyleneaminomethylmethyldiethoxysilane, (N-phenylamino)methyltrimethoxysilane, (N-phenylamino)methyltriethoxysilane, (N-phenylamino)methylmethyldimethoxysilane, (N-phenylamino)methylmethyldiethoxysilane, 3-(N-phenylamino)propyltrimethoxysilane, 3-(N-phenylamino)propyltriethoxysilane, 3-(N-phenylamino)propylmethyldimethoxysilane, 3-(N-phenylamino)propylmethyldiethoxysilane, and N-(N-butyl)-3-aminopropyltrimethoxysilane. The amino silane compounds may be used alone or as a mixture type.

The light stabilizer may capture an active species for initiating the photo-induced degradation of a resin according to the use of the composition applied to play a role in preventing photooxidation. The kind of the light stabilizer used is not specifically limited, for example, known compounds such as a hindered amine-based compound and a hindered piperidine-based compound may be used.

The UV absorber, according to the use of the composition, absorbs ultraviolet rays from the sunlight, etc. and transform into harmless thermal energy in a molecule, and may play the role of preventing the excitation of the active species for initiating the photo-induced degradation in the resin composition. Particular kinds of the UV absorber used is not specifically limited, but, for example, benzophenone-based, benzotriazole-based, acrylonitrile-based, metal complex-based, hindered amine-based, inorganic UV absorber such as ultrafine titanium oxide particles and ultrafine zinc oxide particles may be used alone, or a mixture of two or more thereof may be used.

In addition, examples of the thermal stabilizer may include a phosphor-based thermal stabilizer such as tris(2,4-di-tert-butylphenyl)phosphite, bis[2,4-bis(1,1-dimethylethyl)-6-methylphenyl]ethylester phosphorous acid, tetrakis(2,4-di-tert-butylphenyl) [1,1-biphenyl]-4,4'-diylbisphosphonate and bis(2,4-di-tert-butylphenyl)pentaerythritoldiphosphite; and a lactone-based thermal stabilizer such as a reaction product of 8-hydroxy-5,7-di-tert-butyl-furan-2-on and o-xylene, and one or two or more thereof may be used.

The contents of the light stabilizer, UV absorber, and thermal stabilizer are not specifically limited. That is, the content of the additive may be appropriately selected considering the use of the resin composition, the shape or density of the additive, etc., and generally, may be appropriately controlled in a range of 0.01 parts by weight to 5 parts by weight based on 100 parts by weight of the total solid content of the encapsulant film composition.

**<Encapsulant film>**

In addition, the present invention provides an encapsulant film including the encapsulant film composition.

The encapsulant film of the present invention may be produced by molding the encapsulant film composition into a film or a sheet shape. The molding method is not specifically limited, and may be produced by making a sheet or film through a common process, for example, a T die process or extrusion. For example, the production of the encapsulant film may be performed by an in situ process using an apparatus in which the preparation of a modified resin composition using the encapsulant film composition, and a process for making a film or a sheet are connected with each other.

The thickness of the encapsulant film may be controlled to about 10 μm to about 2,000 μm, or about 100 μm to about 1250 μm, considering the supporting efficiency and breaking possibility of a device in an optoelectronic device, the weight lightening or workability of the device, etc., and may be changed according to particular use.

**<Solar Cell Module>**

In addition, the present invention provides a solar cell module including the encapsulant film. The solar cell module in the present invention may have a configuration in which gaps between solar cells disposed in series or in parallel are filled with the encapsulant film of the present invention, a glass surface is disposed on a surface hit by sunlight, and a rear surface is protected by a back sheet, but the present invention is not limited thereto, and various types and forms of solar cell modules manufactured by including the encapsulant film in the art may all be applied to the present invention.

The glass surface may be formed using tempered glass in order to protect the solar cell from external impact and prevent damage, and using low iron tempered glass having a low iron content in order to prevent the reflection of sunlight and increase transmittance of sunlight, but the present invention is not limited thereto.

The back sheet is a weather-resistant film for protecting the rear surface of the solar cell module from the outside, and includes, for example, a fluorine-based resin sheet, a metal plate or metal foil such as aluminum, a cyclic olefin-based resin sheet, a polycarbonate-based resin sheet, a poly(meth)acrylic-based resin sheet, a polyamide-based resin sheet, a polyester-based resin sheet, a composite sheet obtained by laminating a weather-resistant film and a barrier film, but is not limited thereto.

In addition, the solar cell module of the present invention may be manufactured according to a method known in the art, except including the above-described encapsulant film.

The solar cell module of the present invention is manufactured using the encapsulant film having excellent volume resistivity, and the encapsulant film may prevent a current from being leaked to the outside of the solar cell module due to the movement of electrons in the solar cell module, and thus a potential induced degradation (PID) phenomenon in which insulation is deteriorated, the current is leaked, and the output of the module is rapidly reduced may be significantly suppressed.

## Examples

Hereinafter, the present invention will be described in more detail according to the examples. However, the following examples are intended to illustrate the present invention, and the scope of the present invention is not limited thereto.

**Preparation Example 1: Preparation of transition metal compound 1**

<Synthesis of *N*-*tert*-butyl-1-(1,2-dimetyl-3*H*-benzo[*b*]cyclopenta[*d*]thiophen-3-yl)-1,1-dimethylsilanamine>

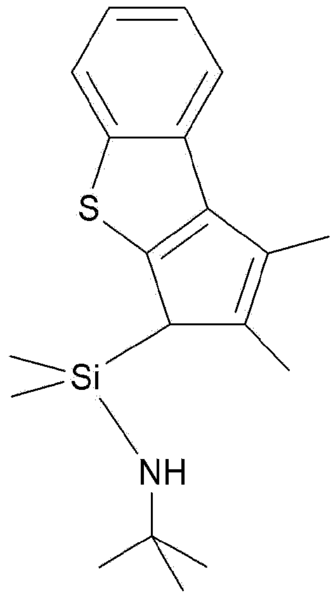

To a 100-mL schlenk flask, 4.65 g (15.88 mmol) of chloro(1,2-dimethyl-3*H*-benzo[*b*]cyclopenta[*d*]thiophen-3-yl) dimethylsilane was weighed and added, and 80 mL of THF was introduced thereto. At room temperature, *t*$BuNH_2$ (4 eq, 6.68 mL) was introduced thereto, followed by reacting at room temperature for 3 days. After the reaction, THF was removed and the resultant reaction product was filtered with hexane. After the solvents were dried, 4.50 g (86%) of a yellow liquid was obtained.

$^1$H-NMR(in $CDCl_3$, 500 MHz): 7.99 (d, 1H), 7.83 (d, 1H), 7.35(dd, 1H), 7.24(dd, 1H), 3.49(s, 1H), 2.37(s, 3H), 2.17(s, 3H), 1.27(s, 9H), 0.19(s, 3H), -0.17(s, 3H).

<Preparation of transition metal compound>

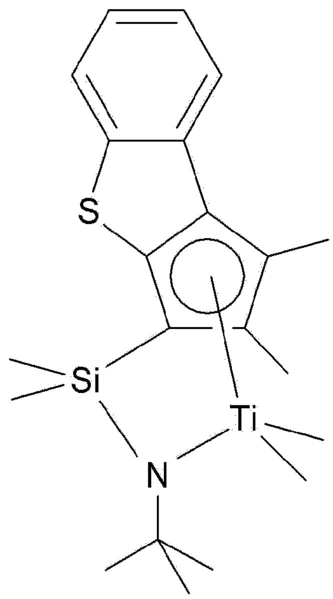

To a 50-mL schlenk flask, the ligand compound (1.06 g, 3.22 mmol/1.0 eq) and MTBE 16.0 mL (0.2 M) were put and stirred first. n-BuLi (2.64 mL, 6.60 mmol/2.05 eq, 2.5 M in THF) was put thereto at -40 °C, followed by reacting at room temperature overnight. Thereafter, MeMgBr (2.68 mL, 8.05 mmol/2.5 eq, 3.0 M in diethyl ether) was slowly added dropwise thereto at - 40 °C, and $TiCl_4$ (2.68 mL, 3.22 mmol/1.0 eq, 1.0 M in toluene) was put in order, followed by reacting at room temperature overnight. Then, the reaction mixture was passed through celite for filtration using hexane. After the solvents were dried, 1.07 g (yield: 82%) of a brown solid was obtained.

$^1$H-NMR(in $CDCl_3$, 500 MHz): 7.99 (d, 1H), 7.68(d, 1H), 7.40(dd, 1H), 7.30(dd, 1H), 3.22(s, 1H), 2.67(s, 3H), 2.05(s, 3H), 1.54(s, 9H), 0.58(s, 3H), 0.57(s, 3H), 0.40(s, 3H), - 0.45(s, 3H).

Preparation Example 2: Preparation of transition metal compound 2

<Synthesis of *N*-*tert*-butyl-1-(1,2-dimetyl-3*H*-benzo[*b*]cyclopenta[*d*]thiophen-3-yl)-1,1-(methyl)(2-methylphenyl)silanamine>

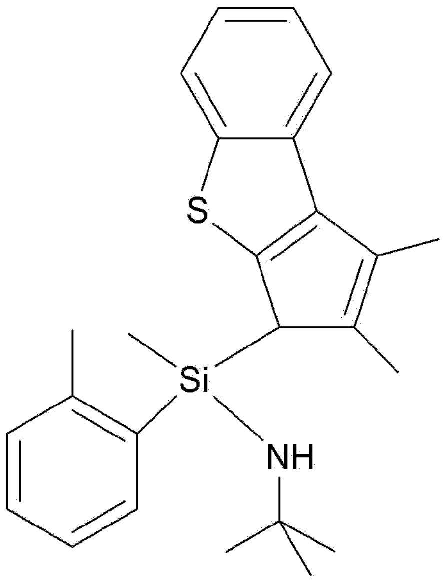

(i) Preparation of chloro-1-(1,2-dimethyl-3*H*-benzo[*b*]cyclopenta[*d*]thiophen-3-yl)-1,1-(methyl)(2-methylphenyl)silane

To a 250-mL schlenk flask, 2.0 g (1.0 eq, 9.985 mmol) of 1,2-dimethyl-3*H*-benzo[*b*]cyclopenta[*d*]thiophene and 50 mL of THF were put, and 4.2 mL (1.05 eq, 10.484 mmol, 2.5 M in hexane) of n-BuLi was added dropwise thereto at -30 °C, followed by stirring at room temperature overnight. The stirred Li-complex THF solution was cannulated into a schlenk flask containing 2.46 g (1.2 eq, 49.925 mmol) of dichloro(O-tolylmethyl)silane and 30 mL of THF at -78 °C, followed by stirring at room temperature overnight. After stirring, drying in vacuum was carried out and extraction with 100 mL of hexane was carried out.

(ii) Preparation of *N*-*tert*-butyl-1-(1,2-dimetyl-3*H*-benzo[*b*]cyclopenta[*d*]thiophen-3-yl)-1,1-(methyl)(2-methylphenyl)silanamine>

Extracted chloro-1-(1,2-dimethyl-3H-benzo[*b*]cyclopenta[*d*]thiophen-3-yl)-1,1-(methyl)(2-methylphenyl)silane (4.0 g, 1.0 eq, 10.0 mmol) was stirred in 10 mL of hexane, and then 4.2 mL (4.0 eq, 40.0 mmol) of t-$BuNH_2$ was introduced thereto at room temperature, followed by stirring at room temperature overnight. After stirring, drying in vacuum was carried out and extraction with 150 mL of hexane was carried out. After the solvents were dried, 4.26 g (99%, dr = 1:0.83) of a sticky liquid was obtained.

$^1$H-NMR($CDCl_3$, 500 MHz): $\delta$ 7.95(t, 2H), 7.70(d, 1H), 7.52(d, 1H), 7.47-7.44(m, 2H), 7.24-7.02(m, 9H), 6.97(t, 1H), 3.59(s, 1H), 3.58(s, 1H), 2.50(s, 3H), 2.44(s, 3H), 2.25(s, 3H), 2.16(s, 3H), 2.06(s, 3H), 1.56(s, 3H), 1.02(s, 9H), 0.95(s, 9H), -0.03(s, 3H), -0.11(s, 3H)

<Preparation of Transition Metal Compound>

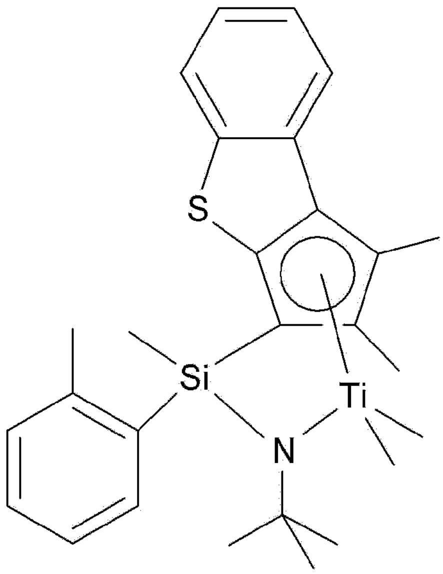

To a 250-mL round flask, the prepared-above *N-tert*-butyl-1-(1,2-dimethyl-3*H*-benzo[*b*]cyclopenta[*d*]thiophen-3-yl)-1,1-(methyl)(2-methylphenyl)silanamine (4.26 g, 10.501 mmol) was put in 53 mL of MTBE (0.2 M), followed by stirring. n-BuLi (8.6 mL, 21.52 mmol, 2.05 eq, 2.5 M in hexane) was put thereto at -40 °C, followed by stirring at room temperature overnight.

Thereafter, MeMgBr (8.8 mL, 26.25 mmol, 2.5 eq, 3.0 M in diethyl ether) was slowly added dropwise thereto at -40 °C, and then $TiCl_4$ (10.50 mL, 10.50 mmol) was added thereto in order, followed by stirring at room temperature overnight. Then, the reaction mixture was filtered using hexane.

DME (3.3 mL, 31.50 mmol) was added to the filtrate, and the solution was filtered and concentrated in hexane to obtain 3.42 g (68%, dr=1:0.68) of a yellow solid.

$^1H$ NMR ($CDCl_3$, 500 MHz) : δ 7.83(d, 1H), 7.80(d, 1H), 7.74(d, 1H), 7.71(d, 1H), 7.68(d, 1H), 7.37(d, 1H), 7.31-6.90(m, 9H), 6.84(t, 1H), 2.54(s, 3H), 2.47(s, 3H), 2.31(s, 3H), 2.20(s, 3H), 1.65(s, 9H), 1.63(s, 9H), 1.34(s, 3H), 1.00(s, 3H), 0.98(s, 3H), 0.81(s, 3H), 0.79(s, 3H), 0.68(s, 3H), 0.14(s, 3H), - 0.03(s, 3H)

**Preparation Example 3: Preparation of ethylene/alpha-olefin copolymer**

While a hexane solvent was introduced at 7 kg/h and 1-butene was introduced at 1.05 kg/h into a 1.5-L continuous process reactor, the reactor was preheated at 150 °C. A triisobutylaluminum compound (0.05 mmol/min), a mixture obtained by mixing a transition metal compound 1 obtained in Preparation Example 1 and a transition metal compound 2 obtained in Preparation Example 2 at a molar ratio of 2.3:1, and a dimethylanilinium tetrakis(pentafluorophenyl)borate cocatalyst (1.5 μmol/min) were simultaneously introduced into the reactor at an equivalent ratio of 1:1.2. Subsequently, ethylene (0.87 kg/h), butene (1.05 kg/h), and hydrogen gas (20 cc/min) were introduced into the reactor, and the mixture was maintained at 135.0 °C for 60 minutes or more in a continuous process at a pressure of 89 bar and a copolymerization reaction was carried out to obtain a copolymer. Then, the copolymer was dried in a vacuum oven for 12 hours or more, and then physical properties were measured.

The physical properties of the ethylene/alpha-olefin copolymer prepared in Preparation Example 3 are shown in Table 1 below. The physical properties of the copolymer were measured as follows.

1) Density

Measurement was conducted according to ASTM D-792-20.

2) Melt Index (MI) and Melt Flow Rate Ratio (MFRR)

$MI_{10}$ and $MI_{2.16}$ were measured according to ASTM D-1238-04 (condition E, $MI_{10}$ (190 °C, 10 kg load), $MI_{2.16}$ (190 °C, 2.16 kg load)), and $MI_{2.16}$ was described as a melt index. Then, $MI_{10}$ was divided by $MI_{2.16}$ to calculate a melt flow rate ratio (MFRR).

[Table 1]

| Density (g/cc) | MI (dg/min) | MFRR |
|---|---|---|
| 0.8737 | 14.7 | 6.9 |

**Example 1**

The ethylene/alpha-olefin copolymer (99.9 wt%) obtained in Preparation Example 3 and porous silica (0.1 wt%) (oil absorption of 149 mL/100 g, specific pore volume of 0.82 mL/g, average particle diameter $D_{50}$ of 2.13 μm, and specific surface area of 554 $m^2$/g) were mixed to pelletize the sample subjected to extrusion blending. Then, 500 g of the pellet was put to Planetary Mixer made by Thermo Electron (Karlsruhe) GmbH, which was preheated to 40 °C, and 1.3 phr (parts per hundred rubber) of t-butyl 1-(2-ethylhexyl)monoperoxycarbonate (TBEC), 0.65 phr of triallyl isocyanurate (TAIC), and 0.26 phr of methacryloxypropyltrimethoxysilane (MEMO) were introduced as additives, and then the pellet was impregnated with the additives while stirring at 40 rpm.

Thereafter, an encapsulant film having an average thickness of 550 μm was prepared using a T-die extruder at a low temperature (under conditions of an extruder barrel temperature of 100 °C or lower) to an extent that high-temperature crosslinking was not performed.

The crosslinking agent impregnation was performed using Planetary Mixer made by Thermo Electron (Karlsruhe) GmbH. To 500 g of the ethylene/alpha-olefin copolymer, 0.5 phr of triallyl isocyanurate (TAIC) and 0.2 phr of methacryloxypropyltrimethoxysilane (MEMO) were introduced, and then stirred at 40 °C at 40 rpm for a sufficient time to allow the crosslinking additives to be absorbed into the ethylene/alpha-olefin copolymer. A change in the torque value over time was observed, and the impregnation was terminated after the torque value increased rapidly.

**Example 2**

An encapsulant film was prepared in the same manner as in Example 1, except that 99.7 wt% of the ethylene/alpha-olefin copolymer obtained in Preparation Example 3 and 0.3 wt% of porous silica (oil absorption of 152 mL/100 g, specific pore volume of 0.78 mL/g, average particle diameter $D_{50}$ of 2.10 μm, and specific surface area of 552 $m^2$/g) were used.

**Example 3**

An encapsulant film was prepared in the same manner as in Example 1, except that 99.5 wt% of the ethylene/alpha-olefin copolymer obtained in Preparation Example 3 and 0.5 wt% of porous silica (oil absorption of 148 mL/100 g, specific pore volume of 0.83 mL/g, average particle diameter $D_{50}$ of 2.16 μm, and specific surface area of 556 $m^2$/g) were used.

**Example 4**

An encapsulant film was prepared in the same manner as in Example 1, except that 99.3 wt% of the ethylene/alpha-olefin copolymer obtained in Preparation Example 3 and 0.7 wt% of porous silica (oil absorption of 146 mL/100 g, specific pore volume of 0.84 mL/g, average particle diameter $D_{50}$ of 2.11 μm, and specific surface area of 557 $m^2$/g) were used.

**Example 5**

An encapsulant film was prepared in the same manner as in Example 1, except that 99.0 wt% of the ethylene/alpha-olefin copolymer obtained in Preparation Example 3 and 1.0 wt% of porous silica (oil absorption of 150 mL/100 g, specific pore volume of 0.79 mL/g, average particle diameter $D_{50}$ of 2.06 μm, and specific surface area of 549 $m^2$/g) were used.

**Comparative Example 1**

An encapsulant film was prepared in the same manner as in Example 1, except that 100 wt% of the ethylene/alpha-olefin copolymer obtained in Preparation Example 3 was used.

**Comparative Example 2**

An encapsulant film was prepared in the same manner as in Example 1, except that 98.0 wt% of the ethylene/alpha-olefin copolymer obtained in Preparation Example 3 and 2.0 wt% of porous silica (oil absorption of 145 mL/100 g, specific pore volume of 0.85 mL/g, average particle diameter $D_{50}$ of 2.07 μm, and specific surface area of 552 $m^2/g$) were used.

**Comparative Example 3**

An encapsulant film was prepared in the same manner as in Example 1, except that 95.0 wt% of the ethylene/alpha-olefin copolymer obtained in Preparation Example 3 and 5.0 wt% of porous silica (oil absorption of 141 mL/100 g, specific pore volume of 0.85 mL/g, average particle diameter $D_{50}$ of 2.14 μm, and specific surface area of 556 $m^2/g$) were used.

**Experimental Example 1: Method for measuring physical properties of silica**

The physical properties of silica used in Examples and Comparative Examples were measured by the following method prior to the use of silica.

(1) Oil Absorption (mL/100g)

The oil absorption of porous silica was measured according to the method provided by JIS K5101.21.

(2) Specific Pore Volume (mL/g)

BET specific surface area was measured using BELSORPmini II (model name) made by BEL Japan, Inc. After a rod and a filter were mounted on an empty sample cell in order to remove moisture, vacuum treatment was performed at 150 °C, and then the sample cell was cooled at room temperature to measure the weight (a) of the sample cell. At least 0.05 g of a sample was introduced into the cell, a rod and a filter were mounted, then the weight was measured, and then vacuum treatment was performed at 150 °C for 1 hour. After purging at room temperature and atmospheric pressure, the weight (b) of the sample cell containing the sample was measured. The weight (b-a) of the exact sample obtained by the above process was input and measured under the conditions of Ads Temp (77K), Sat. vapor pressure (Actural measure), Adsorptive (N2), sample cell diameter (7.0 mm), Molec.Dia (0.364 nm), Glass rod D (6.0mm), and Ads.P/P0 upper limit (0.3). After the measurement, an amount of nitrogen gas adsorbed was obtained, and the results of nitrogen gas adsorption/desorption (P/P0, range of 0.1 to 0.99) were calculated by a predetermined method to calculate the specific pore volume.

(3) Average particle diameter (μm)

An average particle diameter was measured using HELOS KR VIBRI RODOS M (model name) made by SYMPATEC, Gmbh. R4 lens capable of measuring particle size in the range of 0.5-350 μm was used and the appropriate trigger condition for a sample was selected. First, a reference was measured without adding the sample to set the equipment to zero, and then 0.1-0.3 g of the sample was injected into a funnel to start measurement. When the measurement was completed, $D_{50}$ and span values were obtained.

(4) Specific surface area (m2/g)

BET specific surface area was measured using BELSORPmini II (model name) made by BEL Japan, Inc. After a rod and a filter were mounted on an empty sample cell in order to remove moisture, vacuum treatment was performed at 150 °C, and then the sample cell was cooled at room temperature to measure the weight (a) of the sample cell. At least 0.05 g of a sample was introduced into the cell, a rod and a filter were mounted, then the weight was measured, and then vacuum treatment was performed at 150 °C for 1 hour. After purging at room temperature and atmospheric pressure, the weight (b) of the sample cell containing the sample was measured. The weight (b-a) of the exact sample obtained by the above process was input and measured under the conditions of Ads Temp (77K), Sat. vapor pressure (Actural measure), Adsorptive (N2), sample cell diameter (7.0 mm), Molec.Dia (0.364 nm), Glass rod D (6.0mm), and Ads.P/P0 upper limit (0.3). After the measurement, an amount of nitrogen gas adsorbed was obtained to calculate the BET specific surface area.

(5) -OH content (wt%) of silanol group

The measurement was performed using TGA made by Mettler Toledo, Inc. After a pan was placed in an autosampler, the tare function was operated to set the equipment to zero, and 4-6 mg of the sample was weighed and put in the pan. The measurement was performed under the condition that $N_2$ gas flowed at 50 mL/min, and the temperature was increased from the initial stabilization temperature of 30 °C to 150 °C by 30 °C per minute. The remaining moisture was completely removed by maintaining the temperature at 150 °C for 30 minutes, and then the temperature was elevated to 950 °C by 30 °C per minute.

The weight (c) of silica excluding moisture was calculated by subtracting the reduced weight (b) from 30 °C to 150 °C from the total weight (a) of silica. The reduced weight (d) from 150 °C to 950 °C was divided by the weight (c) of silica excluding moisture, thereby measuring the content of - OH groups in the silanol groups in the silica.

[Table 2]

| | Porous silica content (wt%) | Oil absorption (mL/100g) | Specific pore volume (mL/g) | Average diameter $D_{50}$ (μm) | Specific surface area ($m^2/g$) | -OH content (wt%) of silanol group |
|---|---|---|---|---|---|---|
| Example 1 | 0.1 | 149 | 0.82 | 2.13 | 554 | 3.5 |
| Example 2 | 0.3 | 152 | 0.78 | 2.10 | 552 | 3.6 |
| Example 3 | 0.5 | 148 | 0.83 | 2.16 | 556 | 3.7 |
| Example 4 | 0.7 | 146 | 0.84 | 2.11 | 557 | 3.4 |
| Example 5 | 1.0 | 150 | 0.79 | 2.06 | 549 | 3.7 |
| Comparative Example 1 | - | - | - | - | - | - |
| Comparative Example 2 | 2.0 | 145 | 0.85 | 2.07 | 552 | 3.4 |
| Comparative Example 3 | 5.0 | 141 | 0.86 | 2.14 | 556 | 3.6 |

**Experimental Example 2: Si-O band integral value/C-H band integral value**

The ethylene/alpha-olefin copolymers used in Examples and Comparative Examples were subjected to T-die molding without adding a crosslinking agent to make a sheet having a thickness of about 0.5 mm, and then the sheet was analyzed in a transmission mode using Invenio S (Bruker) FT-IR. After the sample was introduced into 10 mm aperture, the infrared absorption rate of a region of 4000 $cm^{-1}$ was measured at a wavenumber of 400 $cm^{-1}$ under the conditions of 4 $cm^{-1}$ resolution and 32 average. After the peak area of the silica characteristics for each sample was obtained, the peak area of the silica characteristics was divided by the reference peak area corresponding to the CH band in order to correct the thickness deviation, thereby calculating the normalized Si-O band area.

In this case, with respect to the integration method, for the Si-O band, the region from 1247 $cm^{-1}$ to 1016 $cm^{-1}$ was integrated, and for the C-H band, the region from 2110 $cm^{-1}$ to 1975 $cm^{-1}$ was integrated.

[Table 3]

| | Si-O band integral value | C-H band integral value | Integral ratio (Si-O band integral value/C-H band integral value) |
|---|---|---|---|
| Example 1 | 44.95 | 7.728 | 5.816 |
| Example 2 | 98.621 | 7.507 | 13.138 |
| Example 3 | 168.378 | 8.058 | 20.896 |
| Example 4 | 224.593 | 7.895 | 28.448 |
| Example 5 | 321.591 | 7.621 | 42.194 |
| Comparative Example 1 | 18.735 | 7.672 | 2.442 |
| Comparative Example 2 | 608.078 | 7.542 | 80.626 |
| Comparative Example 3 | 1491.299 | 7.495 | 198.973 |

As shown in Table 3, Examples 1 to 5 are compositions for an encapsulant film having an integral ratio of 3 to 70, and Comparative Examples 1 to 3 are out of the above range.

**Experimental Example 3**

(1) Transfer rate of crosslinking agent

The encapsulant films (10 cm × 10 cm) prepared in Examples and Comparative Examples were left in a chamber at - 5 °C for one week to promote the transfer of the crosslinking agent. The encapsulant films were washed in cold MeOH, and the additives transferred to the surfaces of the encapsulant films were washed with MeOH.

The MeOH with which the encapsulant films were washed was distilled in vacuum to evaporate the MeOH that is a solvent, thereby obtaining a transferred crosslinking agent as a residue. The weight of the crosslinking agent was measured and divided by the weight of the introduced crosslinking agent in Examples and Comparative Examples to calculate the transferred ratio (Equation 1 below).

Transfer rate of crosslinking agent (%) = [weight of crosslinking agent transferred to surface of encapsulant film/total weight of crosslinking agent] × 100 [Equation 1]

In Equation 1 above,

the weight of the crosslinking agent transferred to the surface of the film is a value measured after preparing an encapsulant film using the encapsulant film composition and then storing the encapsulant film at -5 °C for one week, and

the total weight of the crosslinking agent is the total weight of the crosslinking agent included in the encapsulant film.

(2) Slip resistance

The encapsulant films (10 cm × 10 cm) prepared in Examples and Comparative Examples were left in a chamber at - 5 °C for one week to promote the transfer of the additives. Thereafter, the encapsulant film was taken out from the chamber, placed on a glass substrate (3.2 T embossed low iron glass) at a slope of 45°, and the distance moved for 1 minute was measured and shown in Table 5 below. Since the slip phenomenon of the encapsulant film is accelerated by the transferred crosslinking agent compositions, the moving distance of the encapsulant film increases as the transferred crosslinking agent increases.

(3) Impregnation Time

When the ethylene/alpha-olefin copolymer pellets and the liquid crosslinking agent three components were introduced into the planetary mixer and stirred, before the liquid crosslinking agents were completely absorbed into the pellets, the crosslinking agents act as a lubricant, and thus the torque value (Nm) applied to a mixing blade depending on the soaking time was constantly maintained. Thereafter, when the crosslinking agents were completely absorbed into the pellets, the lubricating effect of the crosslinking agents disappears, and thus the torque value applied to the mixing blade increased rapidly, and the inflection point at this time was defined as the impregnation completion time.

In this case, after performing the soaking operation until the impregnation completion time, the impregnation rate was calculated and confirmed to be 99% or more, thereby cross-verifying whether the impregnation completion time was properly measured.

[Expression 1]

$$\text{Impregnation rate (\%)} = \{1-(W2-W3)/W1\} * 100$$

W1 (g) = total weight of amount of crosslinking agent composition introduced

W2 (g) = weight of dust-free cloth after wiping mixing bowl, mixing blade and soaked pellets after completion of impregnation experiment

W3(g) = weight of dust-free cloth before wiping mixing bowl, mixing blade and soaked pellets before start of impregnation experiment

[Table 4]

| | Transfer rate of crosslinking agent | Slip movement distance (mm) | Impregnation completion time (min) | Impregnation completion time reduced rate (%) |
|---|---|---|---|---|
| Example 1 | 4.10 | 15.2 | 38.5 | 3.8 |
| Example 2 | 2.10 | 9.4 | 35.9 | 10.3 |
| Example 3 | 1.50 | 6.6 | 33.8 | 15.5 |
| Example 4 | 1. 10 | 5.9 | 33.1 | 17.3 |
| Example 5 | 0.80 | 5.5 | 30.5 | 23.8 |
| Comparative Example 1 | 4.54 | 20.1 | 40.0 | - |
| Comparative Example 2 | 0.70 | 5.3 | 24.2 | 39.5 |
| Comparative Example 3 | 0.60 | 4.8 | 21.8 | 45.5 |

As shown in Table 4 above, the encapsulant film composition in Comparative Example 1 has a high transfer rate of the crosslinking agent, and thus the longest slip movement distance is exhibited.

**Experimental Example 4**

(1) Lamination process

After the crosslinking of the encapsulant film, a lamination process was performed in order to measure optical properties and volume resistivity. Specifically, the process was maintained at 150 °C for a total of 20 minutes (vacuum 5 minutes/pressurizing 1 minute/pressure maintenance 14 minutes) to obtain a laminated sheet.

(2) Light transmittance

Light transmittance (380 to 1,100 nm) in the region of visible light of the laminated sheet was measured using Shimadzu UV-3600 spectrophotometer (measurement mode: transmittance, wavelength interval: 1 nm, measurement speed: medium).

(3) Haze

According to ASTM D1003-21 of the American Society for Testing and Materials Standards, the degree (%) of refraction of light was measured when the light was emitted on 1T (1 mm) of the laminated sheet. The haze was obtained by measuring the transparency of the specimen was measured with Td (refracted light)/Tt (transmitted light) x 100 (%).

(4) Volume resistivity

According to ASTM D257-07 of the American Society for Testing and Materials Standards, the laminated sheet was measured by putting a sample in Keithley 8009 test fixture at 23±1 °C and 50±3% humidity, and applying a voltage of 1,000 V for 600 seconds using Keithley 6517B electrometer connected thereto.

(5) Crosslinking properties

According to ASTM D5289-19A, the crosslinking properties were measured using premier MDR made by Alpha Technologies. The test was carried out at 150 °C for 20 minutes and a torque curve was obtained over time. In this case, the 150 °C condition corresponds to a lamination temperature, and 20 minutes corresponds to a lamination time. In addition, the crosslinking properties between the samples were compared using the difference between the maximum torque (MH) and the minimum torque (ML) applied by MDR during such time.

[Table 5]

| | Light transmittance (%T) | Haze | Volume resistivity (Ωcm) | MH-ML (dNm) |
|---|---|---|---|---|
| Example 1 | 92.4 | 1.2 | $1.9 \times 10^{17}$ | 3.52 |

(continued)

| | Light transmittance (%T) | Haze | Volume resistivity (Ωcm) | MH-ML (dNm) |
|---|---|---|---|---|
| Example 2 | 92.5 | 1.4 | $1.6 \times 10^{17}$ | 3.49 |
| Example 3 | 92.3 | 1.5 | $2.9 \times 10^{17}$ | 3.51 |
| Example 4 | 92.0 | 1.5 | $3.5 \times 10^{17}$ | 3.36 |
| Example 5 | 91.9 | 1.6 | $4.3 \times 10^{17}$ | 3.21 |
| Comparative Example 1 | 91.9 | 1.1 | $8.0 \times 10^{16}$ | 3.53 |
| Comparative Example 2 | 90.8 | 7.3 | $3.8 \times 10^{17}$ | 1.94 |
| Comparative Example 3 | 89.3 | 50.4 | $1.4 \times 10^{17}$ | 0.41 |

As shown in Table 5 above, it is confirmed that the compositions for an encapsulant film of Comparative Examples 2 and 3 cannot be effectively used as the encapsulant film due to low light transmittance and high haze, and the crosslinking properties are also deteriorated. In addition, the compositions for an encapsulant film of Examples 1 to 5 according to the present invention exhibit excellent volume resistivity compared to Comparative Example 1.

## Claims

1. An encapsulant film composition, wherein a ratio of an Si-O band integral value to a C-H band integral value (Si-O band integral value/C-H band integral value) is 3 to 70 when calculated from an FT-IR spectrum.

2. The encapsulant film composition of claim 1, wherein when the encapsulant film composition and a crosslinking agent are used to produce the encapsulant film, the transfer rate of the crosslinking agent represented by Equation 1 below is at most 4.5%:

   Transfer rate of crosslinking agent (%) = [weight of crosslinking agent transferred to surface of encapsulant film/total weight of crosslinking agent] x 100 [Equation 1]

   where, in Equation 1 above,
   the weight of the crosslinking agent transferred to the surface of the film is a value measured after producing an encapsulant film using the encapsulant film composition and then storing the encapsulant film at -5 °C for one week, and
   the total weight of the crosslinking agent is the total weight of the crosslinking agent included in the encapsulant film.

3. The encapsulant film composition of claim 1, wherein a ratio of an Si-O band integral value to a C-H band integral value (Si-O band integral value/C-H band integral value) is 4 to 60 when calculated from an FT-IR spectrum.

4. The encapsulant film composition of claim 1, wherein the transfer rate of the crosslinking agent is 0.1 to 4.3.

5. The encapsulant film composition of claim 1, wherein the encapsulant film composition comprises an ethylene/alpha-olefin copolymer and porous silica.

6. The encapsulant film composition of claim 5, wherein the porous silica has an oil absorption of greater than 40 mL/100g as measured according to ASTM D1483-12 (2016).

7. The encapsulant film composition of claim 5, wherein in the porous silica, a -OH content of a silanol group is at least 1.0 wt% based on the total weight of the porous silica.

8. The encapsulant film composition of claim 1, further comprising at least one selected from the group consisting of an organic peroxide, a crosslinking aid, a silane coupling agent, an unsaturated silane compound, an amino silane compound, a light stabilizer, a UV absorber, and a thermal stabilizer.

9. An encapsulant film comprising the encapsulant film composition of any one of claims 1 to 8.

10. A solar cell module comprising the encapsulant film of claim 9.

## INTERNATIONAL SEARCH REPORT

International application No.
**PCT/KR2023/007772**

**A. CLASSIFICATION OF SUBJECT MATTER**

**C08K 7/26**(2006.01)i; **C08K 3/36**(2006.01)i; **C08L 23/08**(2006.01)i; **C08J 5/18**(2006.01)i; **H01L 31/048**(2006.01)i; **C08K 3/34**(2006.01)i

According to International Patent Classification (IPC) or to both national classification and IPC

**B. FIELDS SEARCHED**

Minimum documentation searched (classification system followed by classification symbols)

C08K 7/26(2006.01); B29B 9/16(2006.01); B29C 47/08(2006.01); C08F 210/02(2006.01); C08F 210/16(2006.01); C08F 255/00(2006.01); C08F 4/6592(2006.01); C08J 5/18(2006.01); C08L 23/04(2006.01); C09K 3/10(2006.01); H01L 31/042(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 봉지재(encapsulant), 필름(film), 태양전지(solar cell), FT-IR, 가교제(cross-linker), 다공성 실리카(porous silica), 실라놀(silanol), 비표면적(surface area)

**C. DOCUMENTS CONSIDERED TO BE RELEVANT**

| Category* | Citation of document, with indication, where appropriate, of the relevant passages | Relevant to claim No. |
|---|---|---|
| Y | JP 2013-211452 A (MITSUBISHI PLASTICS INC.) 10 October 2013 (2013-10-10) See paragraphs [0011], [0020], [0032] and [0054], and claims 1-6. | 1-10 |
| Y | JP 2018-500753 A (DOW GLOBAL TECHNOLOGIES LLC) 11 January 2018 (2018-01-11) See paragraphs [0054]-[0058], [0072]-[0075], [0091] and [0093], and claim 2. | 1-10 |
| A | JP 2017-183479 A (JAPAN POLYETHYLENE CORP.) 05 October 2017 (2017-10-05) See paragraphs [0035], [0037] and [0070]. | 1-10 |
| A | JP 5852234 B2 (MITSUI CHEMICALS TOHCELLO INC.) 03 February 2016 (2016-02-03) See paragraphs [0011] and [0045]. | 1-10 |
| A | JP 2014-208774 A (JAPAN POLYETHYLENE CORP.) 06 November 2014 (2014-11-06) See entire document. | 1-10 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 September 2023** | **08 September 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2023/007772**

| Patent document cited in search report | Publication date (day/month/year) | Patent family member(s) | Publication date (day/month/year) |
|---|---|---|---|
| JP 2013-211452 A | 10 October 2013 | None | |
| JP 2018-500753 A | 11 January 2018 | BR 112017008916 A2 | 26 December 2017 |
| | | BR 112017008916 B1 | 12 April 2022 |
| | | CN 107001693 A | 01 August 2017 |
| | | CN 107001693 B | 21 May 2019 |
| | | EP 3212700 A1 | 06 September 2017 |
| | | EP 3212700 B1 | 14 August 2019 |
| | | ES 2748292 T3 | 16 March 2020 |
| | | JP 6713461 B2 | 24 June 2020 |
| | | KR 10-2017-0078738 A | 07 July 2017 |
| | | KR 10-2471541 B1 | 29 November 2022 |
| | | US 2017-0338360 A1 | 23 November 2017 |
| | | WO 2016-070087 A1 | 06 May 2016 |
| JP 2017-183479 A | 05 October 2017 | JP 6736946 B2 | 05 August 2020 |
| JP 5852234 B2 | 03 February 2016 | CN 104245272 A | 24 December 2014 |
| | | EP 2842717 A1 | 04 March 2015 |
| | | EP 2842717 B1 | 15 August 2018 |
| | | KR 10-1644733 B1 | 01 August 2016 |
| | | KR 10-2015-0004388 A | 12 January 2015 |
| | | MY 167962 A | 09 October 2018 |
| | | TW 201343366 A | 01 November 2013 |
| | | TW I615264 B | 21 February 2018 |
| | | US 2015-0084230 A1 | 26 March 2015 |
| | | US 9757888 B2 | 12 September 2017 |
| | | WO 2013-161273 A1 | 31 October 2013 |
| JP 2014-208774 A | 06 November 2014 | None | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020220107003
- KR 1020220112873
- KR 1020230043750
- JP 2015211189 A